# EUROPEAN PATENT APPLICATION

(11) **EP 3 208 366 A1**
(43) Date of publication of application: **23.08.2017**
(21) Application number: 16155959.6
(22) Date of filing: 16.02.2016
(51) Int. Cl.: C30B 29/06, C30B 33/02, C30B 13/00, H01L 21/324

(54) **FZ SILICON AND METHOD TO PREPARE FZ SILICON**

(71) Applicant: Siltronic AG, 81737 München (DE)
(72) Inventor: Huber, Alois, 84489 Burghausen (DE); Lenz, Andrej, 84529 Tittmoning (DE)
(74) Representative: Killinger, Andreas

(57) **Abstract**

FZ silicon, annealed at an annealing temperature of greater than or equal to 900°C, wherein the FZ silicon shows no degradation of its minority carrier lifetime after any processing steps at a processing temperature of less than 900 °C. Method to prepare FZ silicon, comprising annealing the FZ silicon at an annealing temperature of greater than or equal to 900°C and processing the annealed FZ silicon at a processing temperature of less than 900 °C.

## Description

The invention relates to float-zone pulled monocrystalline silicon, hereafter referred to as FZ silicon, and a method to prepare such FZ silicon.

Silicon monocrystals are produced in most practical cases by a crucible pulling method (called Czochralski method or CZ method) or by a crucible-free pulling method (called zone-melting method or FZ method). The rod-shaped monocrystals having diameters of typically 100 up to 450 mm serve principally as basic material for producing wafers, from which electronic components or solar cells are in turn manufactured.

In the CZ method, a melt of the semiconductor material is prepared in a quartz crucible, and a seed crystal is brought into contact with the melt surface and slowly lifted from the melt. A single crystal starts to grow on the bottom side of the seed crystal. On the other hand, solar applications may benefit economically from a socalled continuous Czochralski process in which multiple ingots are drawn from a crucible which is recharged with silicon during the drawing process

In the FZ method, a polycrystalline stock rod is gradually melted with the aid of a radiofrequency coil. The molten material is converted into a single crystal by seeding with a monocrystalline seed crystal and by subsequent recrystallization. During the recrystallization, the diameter of the resulting single crystal is firstly conically enlarged (cone formation) until a desired final diameter is reached (rod formation). In the cone-formation phase, the single crystal is also mechanically supported, in order to relieve the load on the thin seed crystal. The basics of the FZ method are described, for example, in US 6,840,998 B2

One variant of the FZ method, which is referred to as the GFZ method hereinafter, uses polycrystalline granular silicon instead of a feed rod. While the FZ method makes use of one induction heating coil for melting the feed rod and for the controlled crystallization of the single crystal, the GFZ method makes use of two induction heating coils. The polycrystalline granules are melted with the aid of a first induction heating coil on a plate and subsequently flow through a hole in the center of the plate to the growing single crystal and form a melt zone. The crystallization of the single crystal is controlled with the aid of a second induction heating coil, which is arranged below the first induction heating coil. Further details concerning the GFZ method are described, for example, in US 2011/0095018 A1.

All monocrystalline silicon produced by the CZ process contains low but significant levels of oxygen in the ingot, typically at concentrations of about 20 ppma (parts per million atomic) relative to the silicon. The oxygen originates primarily from the quartz crucible. At the growth temperature, most of the oxygen is interstitial in the lattice, that is, single oxygen atoms residing in the interstices of the crystalline silicon lattice. However, some of the oxygen agglomerates together in various atomic configurations, also called cluster or oxygen precipitate nuclei.

The initial clusters and nuclei are referred to as "grown in" defects. Both nuclei and precipitates are considered to be defects in the lattice which act as recombination centers or traps for electrons and holes in the crystalline solid, thereby decreasing the minority carrier recombination lifetime. Removal or elimination of these oxygen defects increases the minority carrier lifetime in the silicon. For CZ silicon, various techniques are applied to reduce the oxygen concentration in the ingot to below 13 ppma but the techniques introduce operational constraints and have not been completely successful. Most modern IC's have active semiconductor devices formed in a surface region within about a few microns of the original wafer surface. It has been proposed to subject the silicon wafer to a fast anneal in a rapid thermal processing (RTP) chamber at a temperature of greater than 1150 °C in an oxygen ambient. Such high-temperature oxygen anneal reduces vacancies and thus prevents precipitation near the surface region during high-temperature processing used for IC's.

Single crystal silicon produced by the float zone (FZ) process, which does not use a quartz crucible, contains little if any oxygen.FZ silicon exhibits very high minority carrier lifetimes arising from the absence of oxygen defects.

US 6,840,998 B2 refers to silicon single crystal produced by crucible-free float zone pulling, comprising a silicon single crystal having a diameter of at least 200 mm over a length of at least 200 mm and being free of dislocations in a region of said length.

US 7,025,827 B2 claims a process for producing a doped semiconductor wafer by float zone pulling of a single crystal and dividing up the single crystal comprising during the float zone pulling, a molten material which is produced using an induction coil is doped with a dopant; exposing the molten material to at least one rotating magnetic field; solidifying the molten material to produce a single crystal; rotating the single crystal which is formed during the solidification of the molten material; and rotating the single crystal and the magnetic field with opposite directions of rotation and the magnetic field having a frequency of 400 to 700 Hz.

Neutron Transmutation Doped (NTD) silicon has the lowest resistivity variation of any crystalline silicon products known. Neutron transmutation doping is the nuclear conversion of semiconductor materials atoms into dopant, i.e., silicon atoms into phosphorus dopant atoms by exposing undoped silicon crystals to a suitable flux of thermal neutrons in the core of a nuclear reactor. The advantage of this technique is the chance to fabricate N-doped silicon of extreme homogeneity which is impossible to realize by conventional doping methods. The unavoidable radiation-produced defects can be cured through annealing by appropriate heating for a specified time length at temperatures within the range of from about 500 °C to higher temperatures below the melt temperature of the semiconductor crystalline material. The annealing has no effect with respect to neutron transmutation-produced nuclides, but results in the removal of radiation damage defects through restoration of crystal symmetry and order. This restoration procedure restores the electrical resistivity to the level corresponding to the dopant-content.

US 4,135,951 A claims a method for restoring neutron-doped semiconductor material resistivity and increasing the minority carrier lifetime of said material through annealing, comprising: heating the material to an annealing temperature of around 600 °C or more but below the material melting temperature for a period of one-fourth hour to five hours or more; and cooling the heated material from the annealing temperature to ambient temperature of below about 300° C at a cooling rate of from ¼ °C to about 4 °C per minute.

Typically, FZ wafers are used to process semiconductor devices, e.g. power devices.

However, the demand for higher efficiency also pushes the photovoltaic development to standard semiconductor methods offering similar quality levels as for semiconductor device production. High-efficiency silicon solar cells made from FZ material have the highest quality and are outperforming CZ monocrystalline silicon and multicrystalline silicon.

Critical parameters of substrates for power devices as well as for photovoltaic applications are:
- High minority carrier lifetime
- Low oxygen content
- Low resistivity variation

Thus, minority carrier lifetime is one key parameter to characterize the suitability of FZ wafers for many applications in the fields mentioned above.

The "as grown" or "as pulled" minority carrier lifetime of FZ silicon depends from the resistivity and it ranges from about 100 to more than 6000 µs. As an example, at 2 Ωcm the bulk lifetime exceeds 1000 µs and increases to 4000 µs at 30 Ωcm.

However, the minority carrier lifetime shows also a strong dependency on annealing processes. Annealing at temperatures below 900°C significantly degrades the "as grown" lifetime. It does not matter whether this takes place in oxidative or non-oxidative furnace atmosphere. On the other hand, annealing at a temperature above 900°C does not degrade the lifetime.

Thus, one of the problems to be solved by the invention was to avoid such degradation of the "as grown" lifetime.

This problem is solved by a method to prepare FZ silicon, comprising
a) annealing the FZ silicon at an annealing temperature of greater than or equal to 900 °C
b) processing the annealed FZ silicon at a processing temperatures of less than 900 °C.

The invention is also directed to FZ silicon, annealed at an annealing temperature of greater than or equal to 900 °C, wherein the FZ silicon shows no degradation of its minority carrier lifetime after any processing steps at a processing temperature of less than 900 °C.

In one embodiment the method to prepare FZ silicon comprises a step of mechanically forming a plurality of FZ silicon wafers from a float-zone pulled silicon ingot, wherein at least one of the FZ wafers is annealed at an annealing temperature of greater than or equal to 900 °C and thereafter processed at a processing temperatures of less than 900 °C.

In a further embodiment a float-zone pulled silicon ingot is annealed at an annealing temperature of greater than or equal to 900 °C. After mechanically forming a plurality of annealed FZ silicon wafers from the annealed float-zone pulled silicon ingot, at least one of the annealed FZ wafers is processed at a processing temperatures of less than 900 °C.

An example for the processing of the annealed FZ silicon at a processing temperature of less than 900 °C is the deposition of a polycrystalline silicon layer on a wafer. Such poly deposition is usually performed at about 650 °C. Without a high temperature anneal at 900 °C or higher the lifetime of such wafer with a poly layer would degrade.

The inventors have also shown that annealing at 900 °C or higher can re-install the originally high lifetime of samples that had been degraded by prior thermal treatments below 900 °C.

FZ silicon which has seen such high temperature annealing step remains widely immune against subsequent annealing steps at lower temperatures. Thus, their lifetime does not notably degrade any more.

To understand the origin of these defects, DLTS studies have been performed. Depending on annealing temperature, the formation or annihilation of several deep levels can be observed. The appearance and removal of these peaks during annealing correlate with the lifetime degradation behavior.

In an embodiment of the invention FZ wafers with a diameter of 75 mm, 125 mm, 150 mm or 200 mm are prepared.

In a further embodiment the FZ wafers are nitrogen co-doped to suppress the generation of crystal defects during crystal pulling. Both vacancy and Si interstitial defects can be simultaneously suppressed by a low level of nitrogen doping (about 10¹⁴ cm⁻³). This gives an almost perfect GOI (gate oxide integrity) quality.

In a further embodiment, the radial resistivity variation of the FZ wafers is 12% or below, more preferably 8% or below. This has been achieved through control of striations during the growth of the FZ silicon.

The FZ silicon of this invention comprises a low level of oxygen, preferably less than 1 ppma of oxygen dissolved in the silicon lattice.

In an embodiment the FZ wafers comprise n- or p-type dopants.

In a further embodiment, the FZ silicon is grown from polycrystalline granular silicon using the GFZ method.
The FZ silicon according to the invention is suitable as a substrate for semiconductor devices, in particular for power devices comprising power MOSFETs, IGBTs (insulated-gate bipolar transistor), thyristors and diodes.

The FZ silicon according to the invention is also suitable as a substrate for high-efficiency solar cells.

The features specified in relation to the above-specified embodiments of the method to prepare FZ silicon according to the invention can be correspondingly applied to the FZ silicon according to the invention. Furthermore, the above-specified advantages in relation to the embodiments of the method to prepare FZ silicon according to the invention therefore also relate to the corresponding embodiments of the FZ silicon according to the invention. These and other features of specified embodiments of the invention are described in the claims as well as in the specification. The individual features may be implemented either alone or in combination as embodiments of the invention, or may be implemented in other fields of application. Further, they may represent advantageous embodiments that are protectable in their own right, for which protection is claimed in the application as filed or for which protection will be claimed during pendency of this application and/or continuing applications.

### Detailed description of exemplary embodiments according to the invention

FZ crystals were pulled. The nitrogen level in the puller was chosen to end up in the range of some 10¹⁴ cm⁻³ in the final crystal. To check the role of nitrogen, some crystals were pulled without the addition of nitrogen in the puller.

We used various wafers with thicknesses 1 mm +/- 500 µm. The wafer diameter does not play a significant role, we could observe the described effects from 75mm to 200mm diameter.

The lifetime was measured using the µPCD-tool of Semilab.

Iodine-Ethanol-passivation was used to suppress surface recombination, hence to reveal true bulk lifetime properties. Moderately doped FZ wafers typically reach > 3ms lifetime with this measurement setup.

The annealing was done under oxidative atmosphere in horizontal or vertical furnaces. The hold time was kept 1 h, using standard ramp rates.

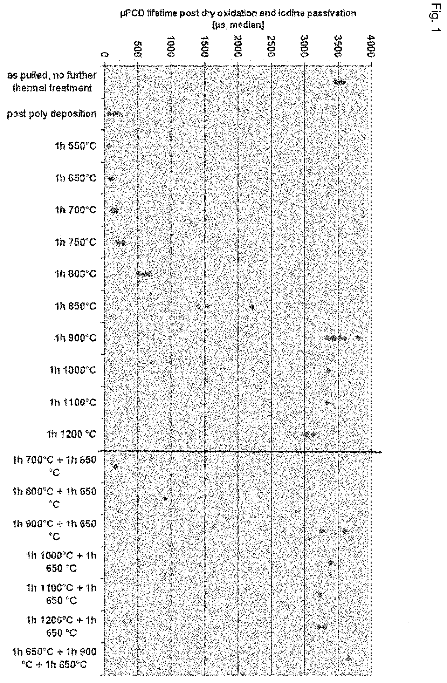

Fig. 1 shows the lifetime of n-doped FZ 200 mm wafers as pulled, with poly backside and after different annealing steps. As mentioned before poly deposition is done at temperatures about 650 °C. Thus, there is a degradation of lifetime.

For wafers as pulled without any thermal treatment the lifetime is about 3500 µs. For wafers with a poly backside the lifetime drops to about 100-200 µs. After annealing steps at 900 °C or above the "as pulled" lifetime is more or less re-installed. If the wafers have seen a pre-anneal at 900 °C or above the poly deposition at 650 °C has no impact on the lifetime.

Thus, results can be summarized as follows:
- Annealing at temperatures below 900 °C degrades the "as grown" lifetime. It does not matter whether this takes place in oxidative or non-oxidative furnace atmosphere
- Annealing at a temperature of 900 °C or higher does not degrade the lifetime
- Annealing at a temperature of 900 °C or higher can re-install the originally high lifetime of samples that had been degraded by prior annealing at temperatures of below 900 °C
- Samples that have seen this high temperature annealing step (temperature of 900 °C or higher) remain widely immune against subsequent annealing at lower temperatures of less than 900 °C. Their lifetime does not notably degrade any more

Subsequent DLTS (Deep-level transient spectroscopy) measurements on these samples revealed characteristic defect levels.

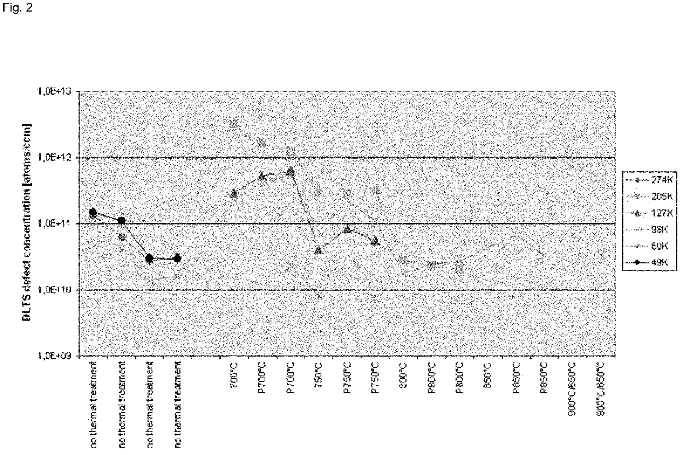

Fig. 2 shows the measured DLTS defect concentrations.

The results can be summarized as follows:
- annealing below 900 °C generates levels at 205 K and 127K
- annealing at 900 °C or above "erases" these defect levels

Since the appearance and removal of these defect levels during annealing well correlates with the lifetime behavior, the defect levels are thought to be the root cause for the lifetime impact. While not wishing to be bound by theory, vacancies and nitrogen might play a role in these defect levels.

The above description of the preferred embodiments has been given by way of example. From the disclosure given, those skilled in the art will not only understand the present invention and its attendant advantages, but will also find apparent various changes and modifications to the structures and methods disclosed. The applicant seeks, therefore, to cover all such changes and modifications as fall within the spirit and scope of the invention, as defined by the appended claims, and equivalents thereof.

## Claims

1. A method to prepare FZ silicon, comprising
- annealing the FZ silicon at an annealing temperature of greater than or equal to 900 °C and
- processing the annealed FZ silicon at a processing temperature of less than 900 °C.

2. The method of claim 1, comprising mechanically forming a plurality of FZ silicon wafers from an FZ pulled ingot.

3. The method claim 1 or claim 2; annealing an FZ pulled ingot at an annealing temperature of greater than or equal to 900 °C.

4. The method of any one of claims 1 to 3, comprising annealing the FZ silicon in an oxygen-containing ambient.

5. The method of any one of claims 1 to 4, processing at least one FZ wafer formed from the FZ silicon at a processing temperature of less than 900 °C.

6. The method of any one of claims 1 to 6, wherein the annealing step is performed in a rapid thermal processing chamber.

7. The method of any one of claims 1 to 7, wherein processing the annealed FZ silicon at a processing temperature of less than 900 °C comprises a step of deposition of polycrystalline silicon on a surface of a FZ wafer.

8. The method of any of claims 1 to 7, wherein the FZ silicon is doped with nitrogen.

9. FZ silicon, annealed at an annealing temperature of greater than or equal to 900°C, wherein the FZ silicon shows no degradation of its minority carrier lifetime after any processing steps at a processing temperature of less than 900 °C.

10. The FZ silicon of claim 9, doped with nitrogen.

11. The FZ silicon of claim 9 or claim 10, comprising a wafer with a diameter of 75 mm, 125 mm, 150 mm or 200 mm.

12. The FZ silicon of claim 11, wherein the wafer contains a polycrystalline silicon surface layer.

13. Use of the FZ silicon according to any one of claims 9 to 12 for the manufacture of semiconductor devices.

14. Use of the FZ silicon according to any one of claims 9 to 12 for the manufacture of high-efficiency solar cells.
